# EUROPEAN PATENT APPLICATION

(11) **EP 4 333 155 A2**
(43) Date of publication of application: **06.03.2024**
(21) Application number: 23190047.3
(22) Date of filing: 07.08.2023
(51) Int. Cl.: H01M 10/42, H01M 50/284, H01M 50/519, H05K 1/18

(54) **BATTERY MODULE**

(30) Priority: 05.09.2022 JP 2022140758
(71) Applicant: Prime Planet Energy & Solutions, Inc., Chuo-ku Tokyo 103-0022 (JP)
(72) Inventor: INAMURA, Takashi, Tokyo, 103-0022 (JP)
(74) Representative: Kuhnen & Wacker Patent- und Rechtsanwaltsbüro PartG mbB

(57) **Abstract**

A control board (900) of a battery module (1) has a connector portion (910), and a flexible printed board (500) has a connection portion (510). The flexible printed board (500) and the control board (900) are electrically connected to each other when the connection portion (510) is connected to the connector portion (910). In a state in which the connection portion (510) is not connected to the connector portion (910), at least a portion of the connection portion of the flexible printed board (500) is located between the control board (900) and the plate member (400) at a region overlapping with the control board (900) when viewed from a first side. The flexible printed board (500) further has a tab (520) that is provided in a vicinity of the connection portion (510) and that protrudes from the region overlapping with the control board (900).

## Description

### CROSS REFERENCE TO RELATED APPLICATIONS

This nonprovisional application is based on Japanese Patent Application No. 2022-140758 filed on September 5, 2022 with the Japan Patent Office, the entire contents of which are hereby incorporated by reference.

### BACKGROUND OF THE INVENTION

### Field of the Invention

The present technology relates to a battery module.

### Description of the Background Art

A flexible printed board may be used as a wiring of a battery module including a plurality of battery cells.

Technologies described in WO 2015/107583, Japanese Patent Laying-Open No. 2007-299794, and Japanese Patent Laying-Open No. 2019-114464 are exemplified as background technologies.

### SUMMARY OF THE INVENTION

In order to improve assemblability of the flexible printed board, it has been required to readily connect a connection portion of the flexible printed board to a connector portion of a control board.

It is an object of the present technology to provide a battery module allowing for high assemblability of a flexible printed board.

The present technology provides the following battery module.
[1] A battery module comprising: a plurality of battery cells arranged in a first direction; a plate member provided on a first side of the plurality of battery cells; and a flexible printed board and a control board each provided on the plate member, wherein the control board has a connector portion, the flexible printed board has a connection portion, and the flexible printed board and the control board are electrically connected to each other when the connection portion is connected to the connector portion, in a state in which the connection portion is not connected to the connector portion, at least a portion of the connection portion of the flexible printed board is located between the control board and the plate member at a region overlapping with the control board when viewed from the first side, and the flexible printed board further has a tab that is provided in a vicinity of the connection portion and that protrudes from the region overlapping with the control board.
[2] The battery module according to [1], wherein the flexible printed board has a film layer and a conductor portion formed on the film layer, and the conductor portion includes a wiring portion electrically connected to the control board, and a dummy portion that is formed on or in a vicinity of the tab and that is not electrically connected to the control board.
[3] The battery module according to [1] or [2], wherein the plate member is provided with a recess or a projection that is each formed in a vicinity of the tab and that each guides a folding line of the flexible printed board.
[4] The battery module according to any one of [1] to [3], wherein the flexible printed board is provided with a notch portion that is formed in a vicinity of a root of the tab and that guides a cutting line of the flexible printed board.
[5] The battery module according to any one of [1] to [4], wherein the flexible printed board includes a first portion and a second portion that branches from the first portion and that includes the connection portion, and the second portion is connected to the control board in an extending direction of the first portion.
[6] The battery module according to [5], wherein a cut-in portion along the extending direction of the first portion is formed between the first portion and the second portion of the flexible printed board.
[7] The battery module according to [5] or [6], wherein the second portion of the flexible printed board has an increased-width portion at a side portion contiguous to the connection portion, the increased-width portion having a relatively large width.
[8] The battery module according to any one of [5] to [7], wherein the second portion of the flexible printed board includes a first side portion formed along the extending direction of the first portion and a second side portion substantially orthogonal to the first side portion.

The foregoing and other objects, features, aspects and advantages of the present invention will become more apparent from the following detailed description of the present invention when taken in conjunction with the accompanying drawings.

### BRIEF DESCRIPTION OF THE DRAWINGS

Fig. 1 is a diagram showing a basic configuration of a battery module.
Fig. 2 is a perspective view showing a battery cell.
Fig. 3 is a perspective view showing a state in which a wiring module is provided on the battery module.
Fig. 4 is a diagram showing an arrangement of bus bars in a battery assembly.
Fig. 5 is a perspective view showing a flexible printed board provided on a plate member.
Fig. 6 is a diagram showing an exemplary positional relation between a connection portion of the flexible printed board and a connector portion of a control board.
Fig. 7 is a diagram showing an exemplary shape of the flexible printed board around the connection portion.
Fig. 8 is a first diagram showing a shape of a conductor portion around a tab of the flexible printed board.
Fig. 9 is a second diagram showing a shape of the conductor portion around the tab of the flexible printed board.
Fig. 10 is a first cross sectional view of the flexible printed board and the plate member around the tab.
Fig. 11 is a second cross sectional view of the flexible printed board and the plate member around the tab.
Fig. 12 is a third cross sectional view of the flexible printed board and the plate member around the tab.
Fig. 13 is a first diagram showing a shape of a notch portion formed in the vicinity of a root of the tab.
Fig. 14 is a second diagram showing a shape of the notch portion formed in the vicinity of the root of the tab.
Fig. 15 is a third diagram showing a shape of the notch portion formed in the vicinity of the root of the tab.
Fig. 16 is a perspective view showing a flexible printed board according to a modification.
Fig. 17 is a perspective view showing surroundings around an increased-width portion of the flexible printed board shown in Fig. 16.
Fig. 18 is a perspective view showing a flexible printed board according to another modification.

### DESCRIPTION OF THE PREFERRED EMBODIMENTS

Hereinafter, embodiments of the present technology will be described. It should be noted that the same or corresponding portions are denoted by the same reference characters, and may not be described repeatedly.

It should be noted that in the embodiments described below, when reference is made to number, amount, and the like, the scope of the present technology is not necessarily limited to the number, amount, and the like unless otherwise stated particularly. Further, in the embodiments described below, each component is not necessarily essential to the present technology unless otherwise stated particularly. Further, the present technology is not limited to one that necessarily exhibits all the functions and effects stated in the present embodiment.

It should be noted that in the present specification, the terms "comprise", "include", and "have" are open-end terms. That is, when a certain configuration is included, a configuration other than the foregoing configuration may or may not be included.

Also, in the present specification, when geometric terms and terms representing positional/directional relations are used, for example, when terms such as "parallel", "orthogonal", "obliquely at 45°", "coaxial", and "along" are used, these terms permit manufacturing errors or slight fluctuations. In the present specification, when terms representing relative positional relations such as "upper side" and "lower side" are used, each of these terms is used to indicate a relative positional relation in one state, and the relative positional relation may be reversed or turned at any angle in accordance with an installation direction of each mechanism (for example, the entire mechanism is reversed upside down).

In the present specification, the term "battery" is not limited to a lithium ion battery, and may include other batteries such as a nickel-metal hydride battery and a sodium ion battery. In the present specification, the term "electrode" may collectively represent a positive electrode and a negative electrode. Further, the term "electrode plate" may collectively represent a positive electrode plate and a negative electrode plate.

In the present specification, the "battery cell" can be mounted on vehicles such as a hybrid electric vehicle (HEV), a plug-in hybrid electric vehicle (PHEV), and a battery electric vehicle (BEV). It should be noted that the use of the "battery cell" is not limited to the use in a vehicle.

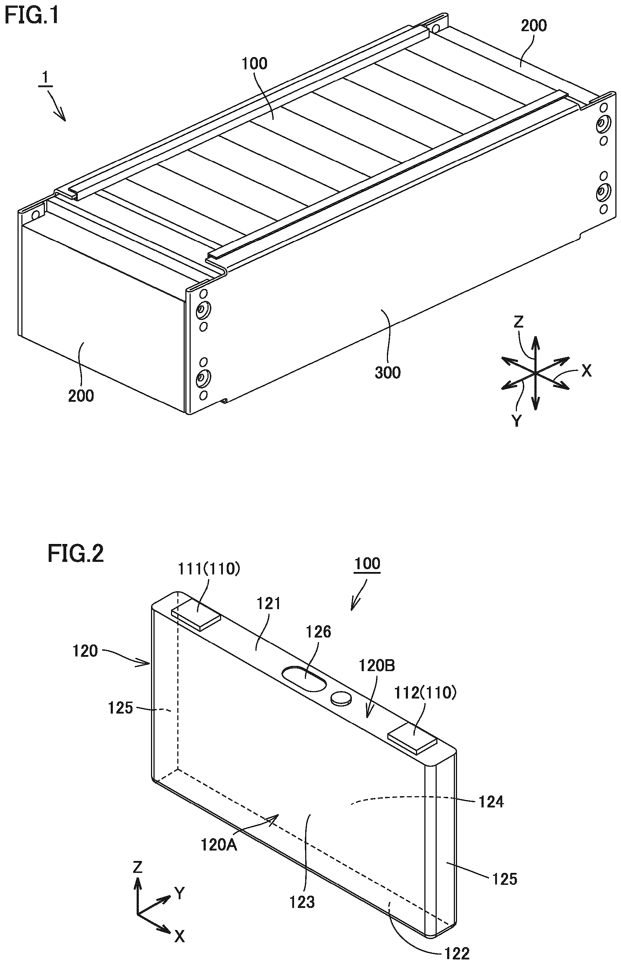

Fig. 1 is a diagram showing a basic configuration of a battery assembly 1. As shown in Fig. 1, battery assembly 1 includes battery cells 100, end plates 200, and a restraint member 300.

The plurality of battery cells 100 are provided side by side in a Y axis direction (first direction). Thus, a stack of battery cells 100 is formed. Each of battery cells 100 includes electrode terminals 110. A separator (not shown) is interposed between the plurality of battery cells 100. The plurality of battery cells 100, which are sandwiched between two end plates 200, are pressed by end plates 200, and are therefore restrained between two end plates 200.

End plates 200 are disposed on both ends of battery assembly 1 in the Y axis direction. Each of end plates 200 is fixed to a base such as a case that accommodates battery assembly 1. Restraint member 300 connects two end plates 200 to each other.

Restraint member 300 is fixed to end plates 200 with a compression force in the Y axis direction being exerted to the stack of the plurality of battery cells 100 and end plates 200, and then the compression force is released, with the result that tensile force acts on restraint member 300 that connects two end plates 200 to each other. As a reaction thereto, restraint member 300 presses two end plates 200 in directions of bringing them closer to each other.

Fig. 2 is a perspective view showing a battery cell 100. As shown in Fig. 2, battery cell 100 has a prismatic shape. Battery cell 100 has electrode terminals 110, and a housing 120 (exterior container). That is, battery cell 100 is a prismatic secondary battery cell.

Electrode terminals 110 are formed on housing 120. Electrode terminals 110 have a positive electrode terminal 111 and a negative electrode terminal 112 arranged side by side along an X axis direction (second direction) orthogonal to the Y axis direction (first direction). Positive electrode terminal 111 and negative electrode terminal 112 are provided to be separated from each other in the X axis direction.

Housing 120 has a rectangular parallelepiped shape and forms an external appearance of battery cell 100. Housing 120 includes: a case main body 120A that accommodates an electrode assembly (not shown) and an electrolyte solution (not shown); and a sealing plate 120B that seals an opening of case main body 120A. Sealing plate 120B is joined to case main body 120A by welding.

Housing 120 has an upper surface 121, a lower surface 122, a first side surface 123, a second side surface 124, and two third side surfaces 125. Housing 120 is provided with a gas-discharge valve 126.

Upper surface 121 is a flat surface orthogonal to a Z axis direction (third direction) orthogonal to the Y axis direction and the X axis direction. Electrode terminals 110 are disposed on upper surface 121. Lower surface 122 faces upper surface 121 along the Z axis direction.

Each of first side surface 123 and second side surface 124 is constituted of a flat surface orthogonal to the Y axis direction. Each of first side surface 123 and second side surface 124 has the largest area among the areas of the plurality of side surfaces of housing 120. Each of first side surface 123 and second side surface 124 has a rectangular shape when viewed in the Y axis direction. Each of first side surface 123 and second side surface 124 has a rectangular shape in which the X axis direction corresponds to the long-side direction and the Z axis direction corresponds to the short-side direction when viewed in the Y axis direction.

The plurality of battery cells 100 are stacked such that first side surfaces 123 of battery cells 100, 100 adjacent to each other in the Y direction face each other and second side surfaces 124 of battery cells 100, 100 adjacent to each other in the Y axis direction face each other. Thus, positive electrode terminals 111 and negative electrode terminals 112 are alternately arranged in the Y axis direction in which the plurality of battery cells 100 are stacked.

Gas-discharge valve 126 is provided in upper surface 121. When the temperature of battery cell 100 is increased (thermal runaway) and internal pressure of housing 120 becomes more than or equal to a predetermined value due to gas generated inside housing 120, gas-discharge valve 126 discharges the gas to outside of housing 120.

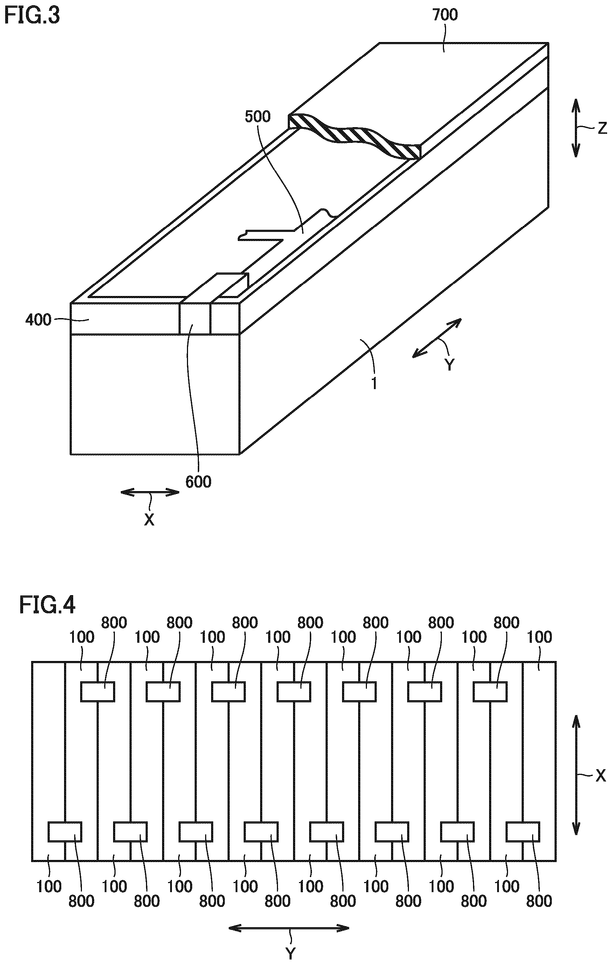

Fig. 3 is a perspective view showing a state in which a wiring module is provided on battery assembly 1. As shown in Fig. 3, a plate member 400 is placed on battery assembly 1, and a flexible printed board 500 is provided on plate member 400. Flexible printed board 500 can be electrically connected to an external device via a connector 600. A cover member 700 is provided on plate member 400 so as to cover flexible printed board 500.

Fig. 4 is a diagram showing an arrangement of bus bars 800 in battery assembly 1. In the example of Fig. 4, positive electrode terminal 111 and negative electrode terminal 112 of adjacent battery cells 100 are electrically connected by bus bar 800, and the plurality of battery cells 100 are electrically connected in series.

That is, battery assembly 1 includes: the plurality of battery cells 100 each having electrode terminals 110 and arranged along a predetermined direction; and bus bars 800 that connect electrode terminals 110 of the plurality of battery cells 100 together.

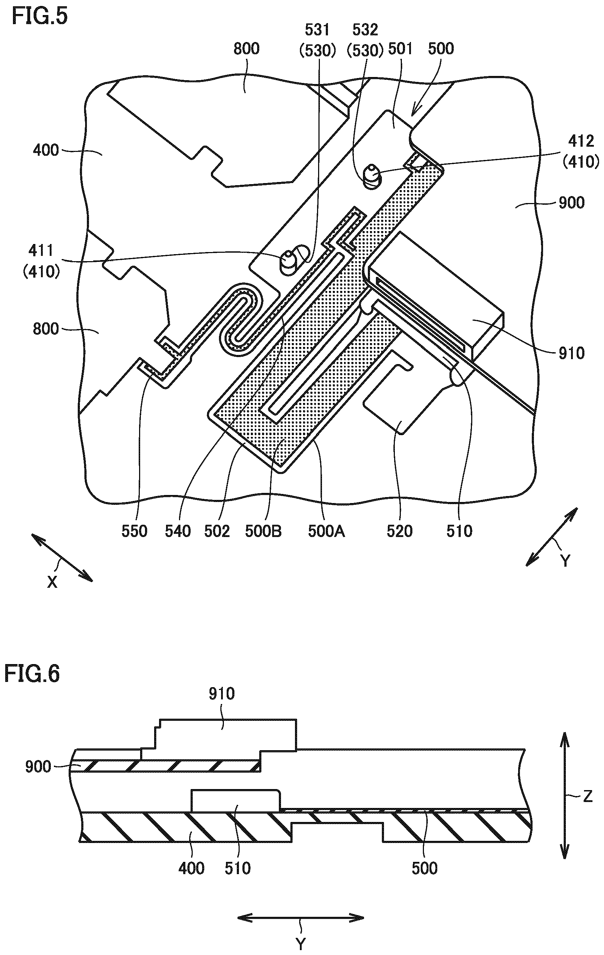

Fig. 5 is a perspective view showing flexible printed board 500 provided on plate member 400. It should be noted that flexible printed board 500 shown in Fig. 5 is one example and the scope of the present technology is not limited thereto.

As shown in Fig. 5, flexible printed board 500 has a connection portion 510 and a tab 520. Control board 900 has a connector portion 910. When connection portion 510 of flexible printed board 500 is connected to connector portion 910 of control board 900, flexible printed board 500 and control board 900 are electrically connected to each other. On this occasion, deflection occurs in flexible printed board 500.

In the example of Fig. 5, flexible printed board 500 includes a main body portion 501 (first portion) and a branch portion 502 (second portion) that branches from main body portion 501. In the example of Fig. 5, connection portion 510 is provided at the tip of branch portion 502. Connection portion 510 provided at branch portion 502 is connected to control board 900 in the extending direction (Y axis direction in the example of Fig. 5) of main body portion 501. On this occasion, branch portion 502 adjacent to connection portion 510 is deflected and deformed.

Flexible printed board 500 is constituted of a film layer 500A and a conductor portion 500B formed on film layer 500A. Film layer 500A is composed of an insulating material. Conductor portion 500B is composed of a metal (conductive material) such as copper, for example.

Plate member 400 has a protruding portion 410. Protruding portion 410 includes a first protruding portion 411 and a second protruding portion 412. Flexible printed board 500 is provided with a hole portion 530, a cut-in portion 540, and a bus bar connection portion 550. Hole portion 530 includes an elongated hole 531 and a round hole 532.

First protruding portion 411 of plate member 400 extends through elongated hole 531 of flexible printed board 500, and second protruding portion 412 extends through round hole 532. Elongated hole 531 is formed to have its long-side direction corresponding to the Y axis direction. With elongated hole 531, flexible printed board 500 can be positioned on plate member 400 while absorbing a dimensional tolerance from elongated hole 531 to round hole 532 in the Y axis direction and an assembly tolerance between plate member 400 and flexible printed board 500.

Cut-in portion 540 is provided between main body portion 501 and branch portion 502 of flexible printed board 500. Cut-in portion 540 is formed along the extending direction (Y axis direction in the example of Fig. 5) of main body portion 501. Bus bar connection portion 550 is a portion of conductor portion 500B, and is provided at the tip of main body portion 501. Bus bar connection portion 550 is connected to bus bar 800.

Fig. 6 is a diagram showing an exemplary positional relation between connection portion 510 of flexible printed board 500 and connector portion 910 of control board 900.

As shown in Fig. 6, in a state in which connection portion 510 is not connected to connector portion 910, i.e., in a state in which no deflection is formed in flexible printed board 500, a portion of connection portion 510 of flexible printed board 500 is located below control board 900. In other words, a portion of connection portion 510 is located between control board 900 and plate member 400 at a region overlapping with control board 900 when viewed from the upper side (first side) of the battery module in the Z axis direction. It should be noted that the whole of connection portion 510 of flexible printed board 500 may be located below control board 900.

Tab 520 shown in Fig. 5 is provided in the vicinity of connection portion 510 and protrudes from the region overlapping with control board 900. By pulling tab 520 in the Y axis direction, connection portion 510 can be pulled out from below control board 900.

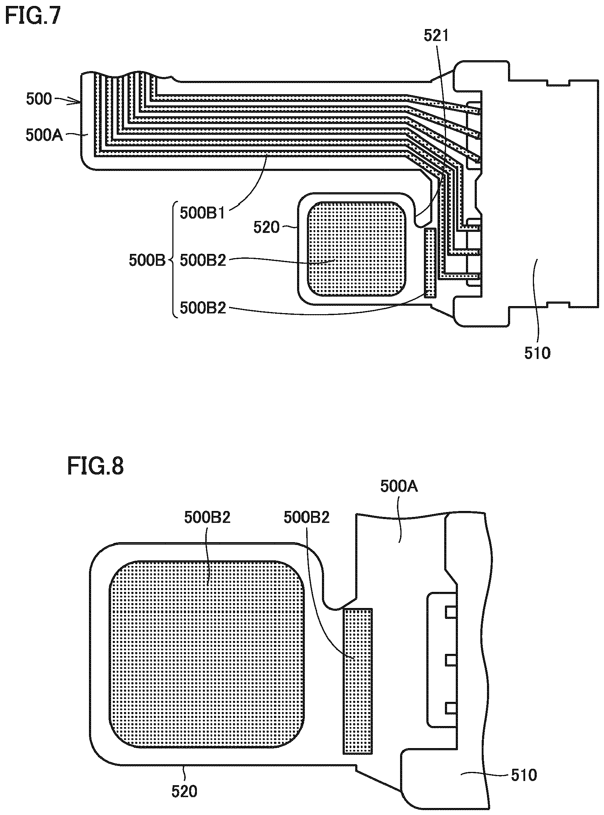

Fig. 7 is a diagram showing an exemplary shape of flexible printed board 500 around connection portion 510.

As shown in Fig. 7, conductor portion 500B of flexible printed board 500 includes a wiring portion 500B1 electrically connected to control board 900, and a dummy portion 500B2 that is formed on or in the vicinity of tab 520 and that is not electrically connected to control board 900.

Wiring portion 500B1 constitutes, for example, a voltage detection line or temperature detection line of battery cell 100. Wiring portion 500B1 and dummy portion 500B2 can be composed of the same type of metal layer.

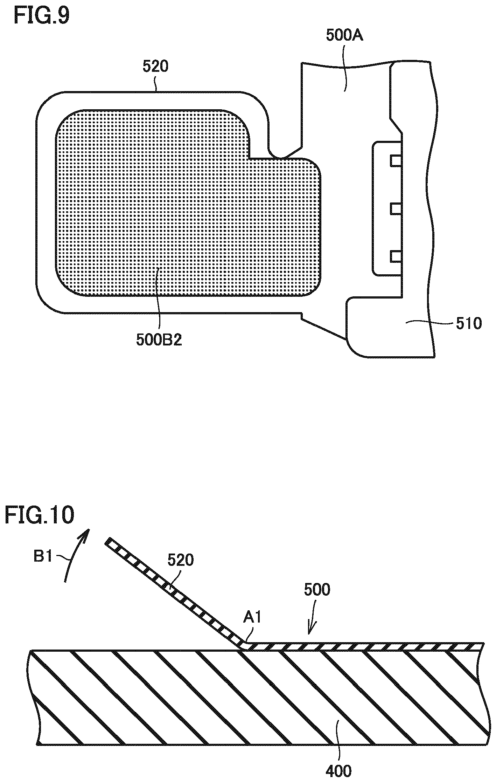

Each of Figs. 8 and 9 is diagram showing a shape of conductor portion 500B around tab 520 of flexible printed board 500.

Dummy portions 500B2 of conductor portion 500B may be formed separately at the central portion of tab 520 and the root portion of tab 520 as in the example of Fig. 8, or a dummy portion 500B2 may be formed continuously from the central portion of tab 520 to the root portion of tab 520 as in the example of Fig. 9. Dummy portion 500B2 of conductor portion 500B can guide a below-described folding line or cutting line to suppress damage of wiring portion 500B1 around tab 520.

Each of Figs. 10 to 12 is a cross sectional view of flexible printed board 500 and plate member 400 around tab 520.

As shown in Fig. 10, by lifting up tab 520 on the tip side from a folding line A1, connection portion 510 can be readily pulled out from below control board 900 with tab 520 being grasped. Since dummy portion 500B2 of conductor portion 500B is formed at an appropriate position on or in the vicinity of tab 520, damage of wiring portion 500B1 due to folding line A1 can be suppressed.

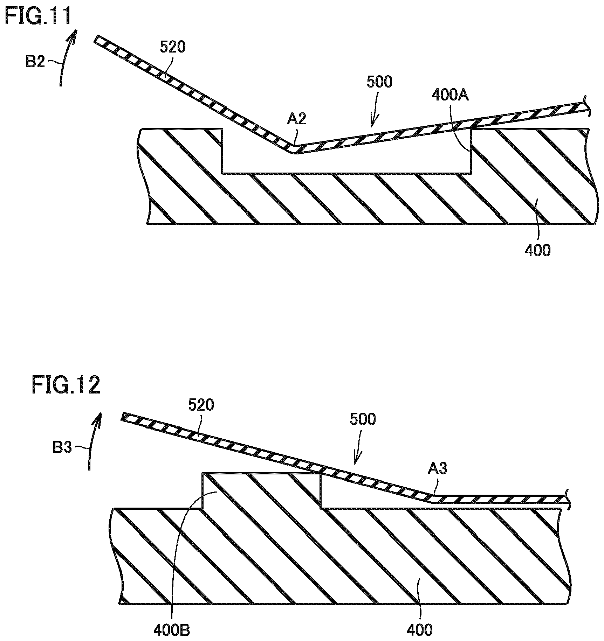

In the example of Fig. 11, a recess 400A is formed in plate member 400 and located below or in the vicinity of tab 520 so as to guide a folding line A2 of flexible printed board 500.

In the example of Fig. 12, a projection 400B is formed in plate member 400 and located below or in the vicinity of tab 520 so as to guide a folding line A3 of flexible printed board 500.

Since recess 400A or projection 400B for conductor portion 500B is formed at an appropriate position below or in the vicinity of tab 520, damage of wiring portion 500B1 due to folding line A2, A3 can be suppressed.

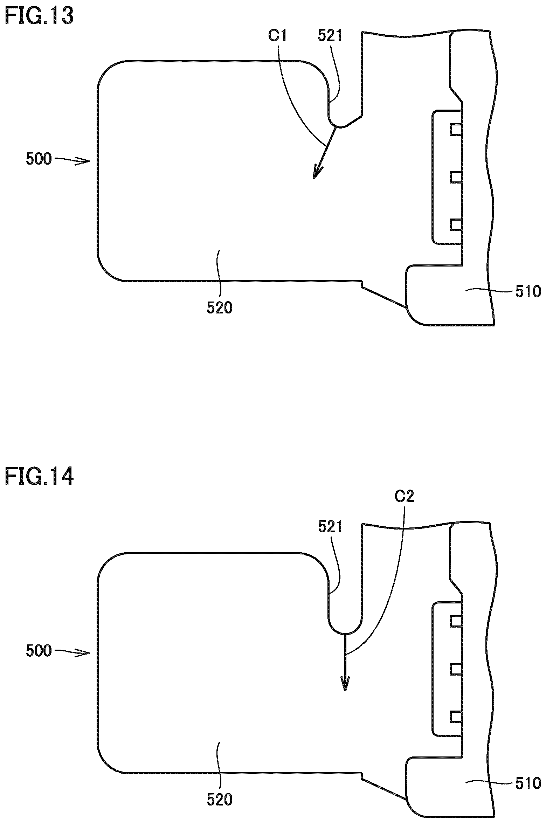

Each of Figs. 13 to 15 is a diagram showing a shape of a notch portion 521 formed in the vicinity of the root of tab 520.

In the example of Fig. 13, notch portion 521 is formed such that the vertex of a curved bottom of notch portion 521 is oriented toward the tip side of tab 520 (side opposite to connection portion 510). As a result, when a cutting line is formed at the root portion of tab 520 at the time of pulling out tab 520 to the left side in the figure, the cutting line is guided in a direction of arrow C1, with the result that damage of wiring portion 500B1 can be suppressed.

In the example of Fig. 14, notch portion 521 is formed such that the vertex of a curved bottom of notch portion 521 is oriented in a direction perpendicular to the protruding direction of tab 520 (direction toward side opposite to connection portion 510). As a result, when a cutting line is formed at the root portion of tab 520 at the time of pulling out tab 520 to the left side in the figure, the cutting line is guided in a direction of arrow C2, with the result that damage of wiring portion 500B1 can be suppressed.

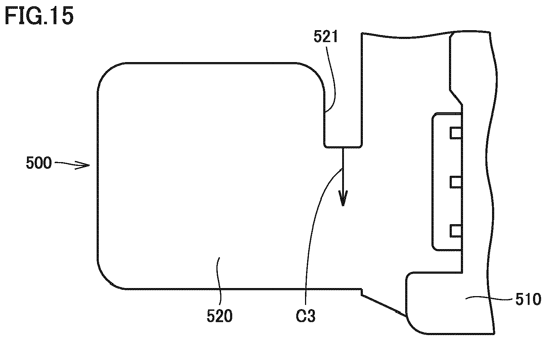

In the example of Fig. 15, notch portion 521 is formed such that a straight-line-shaped bottom of notch portion 521 is oriented in the protruding direction of tab 520. As a result, when a cutting line is formed at the root portion of tab 520 at the time of pulling out tab 520 to the left side in the figure, the cutting line is guided in a direction of arrow C3, with the result that damage of wiring portion 500B1 can be suppressed.

Thus, in each of the examples of Figs. 13 to 15, the cutting line of flexible printed board 500 to suppress damage of wiring portion 500B1 can be guided by notch portion 521. As a result, even when a cutting line is formed around tab 520 at the time of pulling out tab 520, damage of wiring portion 500B1 can be suppressed.

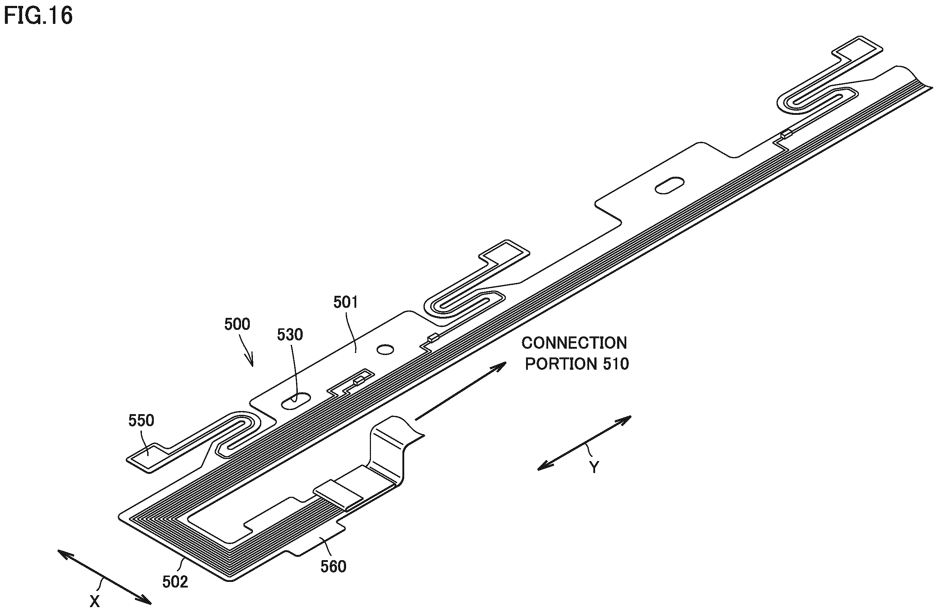

Fig. 16 is a perspective view showing a flexible printed board 500 according to a modification. In the modification shown in Fig. 16, branch portion 502 of flexible printed board 500 has an increased-width portion 560 at a side portion contiguous to connection portion 510, increased-width portion 560 having a relatively large width. Since increased-width portion 560 having a relatively large width is more likely to be deformed than a portion having a narrow width around increased-width portion 560, increased-width portion 560 can be facilitated to enter the inner side with respect to a below-described engagement portion 420, and can be abutted against a wall of a wall portion 430 to stop increased-width portion 560 in the Y axis direction.

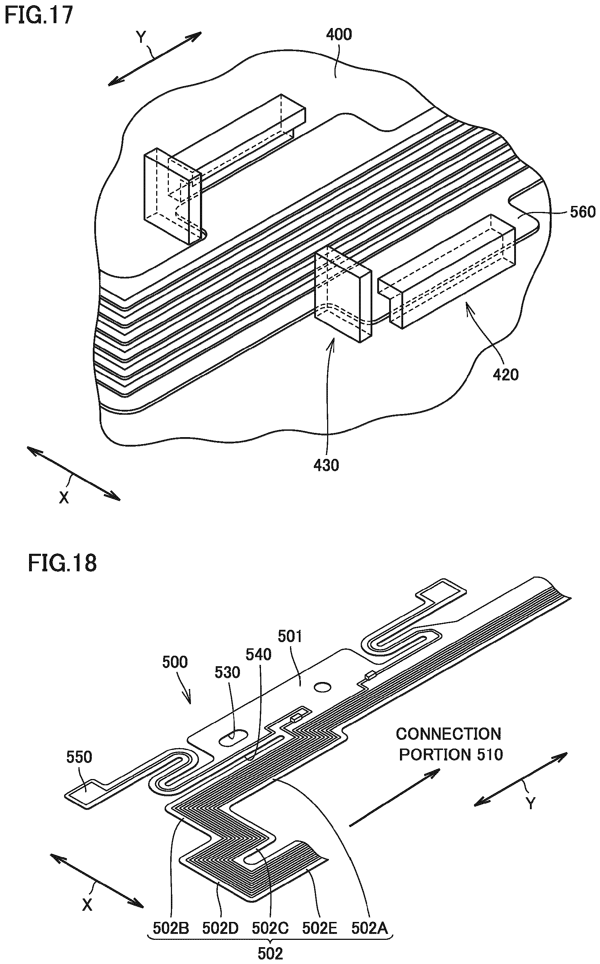

Fig. 17 is a perspective view showing surroundings around increased-width portion 560 of flexible printed board 500 shown in Fig. 16. In the example shown in Fig. 17, engagement portion 420 and wall portion 430 are provided on plate member 400 around increased-width portion 560.

Engagement portion 420 has a substantially L-shaped cross sectional shape, and is engaged with increased-width portion 560 from above, with the result that increased-width portion 560 can be suppressed from rising from plate member 400. Wall portion 430 is abutted against increased-width portion 560 from the rear side of increased-width portion 560 (side opposite to connection portion 510). Since engagement portion 420 and wall portion 430 are provided, connection portion 510 can be readily connected to connector portion 910 of control board 900 with deflection being formed at a desired position on the tip side (the connection portion 510 side) with respect to increased-width portion 560 when pulled out to the rear side with tab 520 being grasped.

Fig. 18 is a perspective view showing a flexible printed board 500 according to another modification. In the modification shown in Fig. 18, branch portion 502 of flexible printed board 500 includes: a first portion 502A formed along the extending direction (Y axis direction) of main body portion 501; a second portion 502B bent with respect to first portion 502A and formed along a direction (X axis direction) substantially orthogonal to first portion 502A; a third portion 502C bent with respect to second portion 502B in a direction away from connection portion 510 and formed to extend in the same direction (Y axis direction) as first portion 502A; a fourth portion 502D bent with respect to third portion 502C and formed along a direction (X axis direction) substantially orthogonal to first portion 502A and third portion 502C; and a fifth portion 502E bent with respect to fourth portion 502D in a direction toward connection portion 510 and formed to extend in the same direction (Y axis direction) as first portion 502A and third portion 502C.

Since the portions (first side portions) formed along the Y axis direction, i.e., first portion 502A, third portion 502C, and fifth portion 502E and the portions (second side portions) along the X axis direction, i.e., second portion 502B and fourth portion 502D are formed alternately multiple times in this way, a displacement absorbing function in the Y axis direction can be improved in branch portion 502 of flexible printed board 500, with the result that flexible printed board 500 can be facilitated to be deflected and deformed and tab 520 can be therefore readily pulled out.

According to the battery module of the present embodiment, since tab 520 protruding from below control board 900 is provided in flexible printed board 500 in the battery module in which at least a portion of connection portion 510 of flexible printed board 500 is disposed at a position overlapping with control board 900 when viewed in the height direction (Z axis direction) of the battery module before connecting connection portion 510 of flexible printed board 500 to control board 900, i.e., in a state in which no deflection is formed in flexible printed board 500, connection portion 510 can be pulled out from below control board 900 with tab 520 being grasped during the process of assembling flexible printed board 500. As a result, assemblability of flexible printed board 500 is improved.

Although the embodiments of the present invention have been described and illustrated in detail, it is clearly understood that the same is by way of illustration and example only and is not to be taken by way of limitation, the scope of the present invention being interpreted by the terms of the appended claims. The scope of the present invention is defined by the terms of the claims, and is intended to include any modifications within the scope and meaning equivalent to the terms of the claims.

## Claims

1. A battery module comprising:
a plurality of battery cells (100) arranged in a first direction;
a plate member (400) provided on a first side of the plurality of battery cells (100); and
a flexible printed board (500) and a control board (900) each provided on the plate member (400), wherein
the control board (900) has a connector portion (910),
the flexible printed board (500) has a connection portion (510), and the flexible printed board (500) and the control board (900) are electrically connected to each other when the connection portion (510) is connected to the connector portion (910),
in a state in which the connection portion (510) is not connected to the connector portion (910), at least a portion of the connection portion (510) of the flexible printed board (500) is located between the control board (900) and the plate member (400) at a region overlapping with the control board (900) when viewed from the first side, and
the flexible printed board (500) further has a tab (520) that is provided in a vicinity of the connection portion (510) and that protrudes from the region overlapping with the control board (900).

2. The battery module according to claim 1, wherein
the flexible printed board (500) has a film layer (500A) and a conductor portion (500B) formed on the film layer (500A), and
the conductor portion (500B) includes a wiring portion (500B1) electrically connected to the control board (900), and a dummy portion (500B2) that is formed on or in a vicinity of the tab (520) and that is not electrically connected to the control board (900).

3. The battery module according to claim 1 or 2, wherein the plate member (400) is provided with a recess (400A) or a projection (400B) that is each formed in a vicinity of the tab (520) and that each guides a folding line of the flexible printed board (500).

4. The battery module according to any one of claims 1 to 3, wherein the flexible printed board (500) is provided with a notch portion (521) that is formed in a vicinity of a root of the tab (520) and that guides a cutting line of the flexible printed board (500).

5. The battery module according to any one of claims 1 to 4, wherein
the flexible printed board (500) includes a first portion (501) and a second portion (502) that branches from the first portion (501) and that includes the connection portion (510), and
the second portion (502) is connected to the control board (900) in an extending direction of the first portion (501).

6. The battery module according to claim 5, wherein a cut-in portion (540) along the extending direction of the first portion (501) is formed between the first portion (501) and the second portion (502) of the flexible printed board (500).

7. The battery module according to claim 5 or 6, wherein the second portion (502) of the flexible printed board (500) has an increased-width portion (560) at a side portion contiguous to the connection portion (510), the increased-width portion (560) having a relatively large width.

8. The battery module according to any one of claims 5 to 7, wherein the second portion (502) of the flexible printed board (500) includes a first side portion (502E) formed along the extending direction of the first portion (501) and a second side portion (502D) substantially orthogonal to the first side portion (502E).
